# EUROPEAN PATENT SPECIFICATION

(11) **EP 0 250 762 B1**
(45) Date of publication and mention of the grant of the patent: **08.03.1995**
(21) Application number: 87106181.8
(22) Date of filing: 28.04.1987
(51) Int. Cl.: G03F 7/26

(54) **Formation of permeable polymeric films or layers via leaching techniques**
Herstellung von permeabelen polymeren Filmen oder Schichten durch Auslaugung
Préparation de films et de couches de polymères, perméables par lixiviation

(30) Priority: 23.06.1986 US 877606
(43) Date of publication of application: 07.01.1988
(73) Proprietor: International Business Machines Corporation, Armonk, N.Y. 10504 (US)
(72) Inventor: Greco, Stephen Edward, Lagrangeville NY 12540 (US); Lyons, Christopher Francis, Lagrangeville NY 12540 (US); Yang, Jer-Ming, Yorktown Heights NY 10598 (US)
(74) Representative: Klein, Daniel Jacques Henri

(56) References cited:
- EP-A- 0 014 943
- EP-A- 0 204 253
- EP-A- 0 244 572
- US-A- 4 198 236
- THIN SOLID FILMS, vol. 85, no. 1, October 1981, pp. 77-85, Elsevier Sequoia, Lausanne, CH ; A. BARRAUD : "Model of the dissolution of monomolecular photoresists"

## Description

The present invention is concerned with a method of rendering a polymeric resist more permeable to liquid and gaseous penetrants and reactants used to alter mechanical, electrical, or chemical-physical properties of the polymeric resist.

Improvements in microlithography have made possible many of the recent advancements in the fabrication of electronic devices. New photoresist systems have been developed which permit the conversion of a single layer of resist to a multilayer resist, thus providing simplified processing techniques while maintaining the high aspect ration (ration of the height or thickness of the patterned resist to the width of pattern features) desired for fabrication of submicron patterned resists. Examples of methods of converting a single layer resist to a multilayer resist are disclosed in European Patent Application 85115321.3 filed 3 December 1985, assigned to the assignee of the present invention, and hereby incorporated by reference.

In addition, techniques have been developed for creating resist systems which are etch-resistant, so that dry development techniques can be used to transfer a pattern from the etch-resistant resist to underlaying layers, thus enabling even better control over the submicron dimensions of the finished electronic device. Although there are several methods of creating etch-resistant resists, many of these methods are complicated, requiring the use of numerous layers of resist material and complex reaction and development schemes.

Recently, techniques have been developed for rendering portions of a single polymeric layer etch-resistant. These microlithographic techniques for converting portions of a single layer of resist to an etch resistant form require the reaction of an organometallic reagent with functional groups within the resist layer. The ability to accomplish this reaction as well as the speed of the reaction depend on the ability of the reagent to contact the functional groups. U.S. Patent No. 4 613 398, assigned to the assignee of the present invention, discloses a method of controlling the ability of the reagent to contact the functional groups through the use of preferential permeation. U.S. Patent Application Serial No. 742,779 is hereby incorporated by reference. Preferential permeation is accomplished by creating a latent pattern having altered permeability to the organometallic reagent within the resist, at least within the upper portion of the resist. The first above mentioned European patent application discloses a technique for converting patterned upper portions of a single layer of resist to a chemical structure which has much higher absorptivity toward actinic radiation than the absorptivity of the resist layer as a whole. The higher absorptivity is used to prevent underlaying portions of resist from photoalteration upon blanket exposure of the entire resist surface to actinic radiation. The difference in absorptivity of the patterned upper portions towards certain actinic radiations is created by treating a single resist layer having a latent pattern of reactive functional groups with a dye or a dye-forming reagent which reacts with functional groups in the patterned areas.

In accordance with the present invention, a method is provided for converting a layer of polymeric material which lacks permeability to a more permeable form. The method can also be used to create or enhance patterned differential permeability within a given polymeric film or layer. It has been discovered that compounds/materials can be added to the polymeric material formulation and subsequently be leached from a film or layer cast from the formulation, to provide increased permeability of the layer as a whole, or to create or enhance permeability differentials within the polymeric layer. The additive used to alter permeability can be a photoactive compound or sensitizer such as the type of materials typically used in photoresists (for example, aryl azides, diazoquinones, and diazo homotetraminic acids), or can be a non-photosensitive or a nonphotoactive material. A photoactive material being a material which undergoes chemical change upon exposure to photons, electrons or ions. The additive used to alter permeability can be a compound/material which is leachable from the film in the same form in which it is added to the formulation, or it may be a compound/material which becomes leachable after treatment of the film with heat or radiation.

This method of increasing permeability within a polymeric layer or enhancing the differential in permeability within a latent pattern in a polymeric layer is particularly useful in photolithographic processes used in the fabrication of electronic devices.

The method of creating enhanced differential permeability in a resist film comprises:
a) providing a polymeric material comprising at least one polymer and one solvent;
b) adding a leachable additive to said polymeric material selected in the group comprising 1-1′-(dodecamethylene) bis (2,4-piperidinedione), 4,4′-bis (dimethylamino)-benzophenone and 4,8-bis((6-diazo-5,6-dihydro-5-oxo-1-naphthanyl sulfonyloxymethyl)tricyclo(5.2.1.02,6) decane to generate a resist formulation;
c) apply said resist formulation onto a substrate to form a resist film;
d) heat treating the resist film to remove the solvent;
e) patternwise irradiating said resist film to create a latent image therein; and,
f) treating the irradiated resist film with an organometallic compound.

The leachable additive or altered derivative thereof can be subsequently leached from particular areas of the resist film by contacting the resist film with the proper solvent to achieve leaching of the leachable additive or derivative thereof from the resist film.

The leachable additive can be removed from the irradiated areas or from the non-irradiated areas, depending on the effect of the irradiation on the resist in the patternwise irradiated areas. There are numerous variations on this general concept. For example: the irradiation of the resist film may chemically alter the leachable additive in irradiated areas to cause this additive to become more soluble in the leaching solvent or less soluble in the leaching solvent; the irradiation may chemically alter the leachable additive so that it becomes reactive with the host polymeric resist material in the formulation (thus the leachable additive cannot be removed from the polymer matrix in the irradiated areas); the irradiation of the resist film may chemically alter the host polymeric material in the resist so that the polymeric matrix in the resist film changes, hindering leachability of the leachable additive in the irradiated areas; the irradiation of the resist film may chemically alter the host polymeric material in the resist so that it reacts with the leachable additive (thus the leachable additive cannot be removed from the polymer matrix in the irradiated areas).

The increase in permeability enables the permeation of particular reagents into the resist, wherein the reagent is used to alter mechanical, electrical, or chemical-physical properties of the polymeric layer.

For example, a novolak resin contains hydroxyl groups which can be reacted with an organometallic compound, such as an organosilicon, to provide oxygen plasma etch resistance. However, some types of novolak resins, when treated with an organosilicon, cannot be silylated (ie. the organosilicon compound does not penetrate the resist layer and react with hydroxyl groups sufficiently to provide the etch resistance). During attempts to develop materials and processes enabling silylation of novolak resists, it was found that many photosensitive materials (sensitizers added to the novolak resist formulation to enable patterning of the resist via exposure to radiation) increase the permeability of the areas of the resist which have been irradiated. This increase in permeability if attributed to the photofragmentation of sensitizers and the evolution of small fragments which increase the permeability of the resist film.

However, addition of certain photosensitive materials to the resist formulation produced unexpected effects on permeability, wherein the silylation in the irradiated areas of the resist was relatively slow compared with the silylation rate in the non-irradiated areas of the resist. After careful analysis of factors affecting permeability of the resist to organometallic reagents, such as but not limited to, porosity, polarity, and swelling properties (e.g., crosslinking and cohesive energy), it was determined that leachability of the photoactive compounds and their reaction products has great effect on permeability of the resist structure. For purposes of the present invention, a leachable material as defined in claim 1 is one which can be removed from the host matrix in which it is present by contact with another material in which the leachable material is soluble. The solvent for the leachable material may be comprised of a solid, liquid, or gas, but preferably a liquid or a gas will be used to remove the leachable additive from the resist, due to speed of the transfer phenomena.

Two basic types of resist structure are used in the microelectronics industry: positive tone resist structures wherein the portion of the resist exposed to the patterned radiation is removed during development of the pattern, and negative tone resist structures wherein the portion of the resist exposed to the patterned radiation remains after development of the pattern.

Positive tone patterns created using preferential permeation typically rely on crosslinking in the irradiated areas of the resist, which leads to a reduction of permeability of the resist material in the irradiated areas. When the resist is subsequently treated with an reagent such as organometallic reagent used to create etch resistance, the reagent permeates the non-crosslinked areas of the resist with minimal permeation of crosslinked areas. Thus, on development of the latent pattern within the resist using an oxygen plasma, the irradiated areas of the resist are removed, since no significant amount of organometallic reagent is present to generate the metallic oxide which prevents etching of the resist material in the irradiated areas.

The amount of leachable additive to be added depends on the particular resist in which it is used, but observations indicate that use of too much leachable additive can cause problems during application of the resist formulation to the substrate and/or an undesirable decrease in resist film thickness during processing. Resist formulations comprising from about 1% to about 50% by weight leachable additive, based on the dry layer of resist (after removal of substantially all of the solvent carrier used during application of the film), can be used, with preferred formulations comprising from about 5% to about 35% leachable additive.

The more generic concepts disclosed in the preceeding summary of the present invention are demonstrated in the embodiments described below.

### EXAMPLE 1

The resist formulation comprised a commercially available meta cresol formaldehyde novolak resin, obtained from Eastman Kodak Co., a deep UV sensitive compound comprised of 1-1′-(dodecamethylene) bis (2,4-piperidinedione) as the leachable additive (a xylene soluble, deep UV photoreactive compound with no apparent silylation reaction sites), and a suitable solvent, (diglyme was used in this case although other solvents or solvent mixtures could be used). The resist formulation was applied to a semiconductor substrate comprising a silicon wafer with a surface of thermal silicon oxide, using standard spin coating techniques and the structure was then heat treated to remove resist formulation solvent. The resist formulation was comprised of about 22% by weight novolak, about 8% piperidinedione sensitizer, and about 70% by weight diglyme.

The resist was exposed to radiation of about 250 nm, at a dosage of about 10 to about 20 mJ/cm2 through a mask with various line/space arrays. The irradiated resist was subsequently treated with a solution of about 5% by volume hexamethylcyclotrisilazane (HMCTS) in xylene. The solution was applied to the surface of the resist at about 65°C for a period of about 12 minutes, followed by a xylene rinse.

The latent image within the resist was developed using oxygen reactive ion etching. Commercially available ion etching equipment can be used and etching conditions appropriate for the given equipment and a given resist can be determined with minimal experimentation.

The irradiated areas of the resist did not silylate significantly; the non-irradiated areas of the resist did silylate. The irradiated areas were removed upon oxygen reactive ion etching to produce a one micron line/space array. Approximately 1.3 microns of the original 1.4 micron thick resist film was retained in the non-irradiated areas after oxygen reactive ion etching.

The novolak resin used in this example is very difficult to silylate by itself, even though it has hydroxyl groups for silylation; when the pure resin was applied to the substrate and treated with the silylating agent as described previously in this example, it was found that the resist had not silylated to any significant degree and the resist layer could be etched away in oxygen.

The silylating solution of HMCTS in xylene used to treat the resist surface was periodically examined by UV spectroscopy, and found to contain characteristic spectrum of the piperidinedione sensitizer, indicating that this compound had been leached out of the film into the silylating solution.

The novolak resin used in this example absorbs appreciably at about 250 nm, the deep UV wavelength at which the resist was patternwise irradiated, thus the latent image created within the resist was within the upper portion of the resist layer (top-imaging). The advantage to top imaging is that underlaying topography does not backscatter the radiation, causing distortion in line widths.

The permeation of the HMCTS silylating formulation into the non-irradiated resist layer was only partial under the HMCTS treatment conditions used in this example. Thus, it was possible to produce resist structures wherein the cross-section of the structure exhibited slightly undercut profiles. The exact resist profile can be tailored by adjusting the silylation conditions and the oxygen plasma etching conditions.

### EXAMPLE 2

The polymeric film formulation comprised the meta cresol novolak resin described in EXAMPLE 1, leachable additive 4,4′-bis (dimethylamino)-benzophenone (a xylene soluble, non photoreactive compound with no apparent reactive sites for silylation), and a diglyme/toluene solvent mixture. The polymerid film formulation was applied to a semiconductor substrate comprising a silicon wafer with a surface of thermal silicon oxide using standard spin techniques, and the structure was heat treated as previously described. The polymeric film formulation was comprised of about 20% by weight novolak, about 5% leachable additive, and about 75% by weight diglyme/toluene solvent mixture (90/10 by volume).

A second polymeric film formulation comprised of the same meta cresol novolak resin and diglyme solvent was spin coated onto the same type of semiconductor substrate and heat treated in the same manner. The polymeric film formulation was comprised of about 22% by weight novolak and about 78% by weight diglyme.

The coated and HMCTS treated wafers were then simultaneously reactive ion etched in oxygen for a time period sufficient to etch away all of the polymeric film cast from the polymeric film formulation which did not contain the 4,4′-bis(dimethylamino)-benzophenone leachable additive. The thickness of polymeric film removed was about 0.65 micrometers. The film which was cast using the leachable additive lost only 0.02 microns of its original 0.73 micron thickness, indicating that presence of the leachable additive permitted a significant degree of silylation which was not otherwise obtained.

### EXAMPLE 3

The polymeric film formulation comprised a terpolymer resin of methacrylic acid, methyl methacrylate, and methacrylic anhydride, the deep UV sensitive piperidinedione compound described in EXAMPLE 1 as the leachable additive, and diglyme solvent. The polymeric film formulation was spin coated onto a semiconductor substrate comprising a silicon wafer with a polished silicon surface, and the resultant structure was heat treated to remove diglyme solvent. The polymeric film formulation was comprised of about 13% by weight of the terpolymer, about 4% by weight of the leachable piperidinedione compound, and about 83% by weight of diglyme solvent.

A second coated substrate was prepared using the same materials and process steps as those described above except that the polymeric film formulation contained no leachable piperidinedione compound. The polymeric film formulation comprised about 14% by weight terpolymer, and about 86% by weight diglyme solvent.

The coated surface of each silicon wafer was treated with a solution of about 10% by weight HMCTS in xylene at about 65°C. The solution was in contact with the coated surface for a period of about 10 minutes. Excess solution was removed with a xylene rinse. The coated wafers were then soaked in tetrahydrofuran for a period of about 2 minutes. The coating film which was cast from the polymeric film formulation which did not contain the leachable piperidinedione compound was completely dissolved from the wafer. The coating film cast from the polymeric film formulation containing the leachable piperidinedione compound showed no signs of attack from the tetrahydrofuran treatment, indicating that the HMCTS, a multifunctional crosslinking agent, had been able to penetrate and crosslink the terpolymer in the coating film.

### EXAMPLE 4

The resist formulation comprised a polyamic acid resin of 2,2-bis(3,4-dicarboxyphenyl) 1,1,1 3,3,3 hexafluoro propane and 4,4′-diaminodiphenyl ether available from Du Pont Chemicals, 4,8-bis((6-diazo-5,6-dihydro-5-oxo-1-naphthanyl sulfonyloxymethyl)tricyclo(5.2.1.02,6)decane as the leachable additive (a xylene soluble, photoreactive compound with no apparent sites for silylation), and a solvent comprising a mixture of 1-methyl-2-pyrrolidinone (NMP) and aromatic petroleum distillates. The resist formulation was applied to a semiconductor substrate comprising a silicon wafer with a thermal silicon oxide surface using standard spin coating techniques. Subsequently the coated wafer was heat treated to remove solvent mixture. The resist formulation was comprised of about 12% by weight of the polyamic acid resin, about 5% by weight of the leachable tricyclodecane photoactive compound, about 62% by weight NMP, and about 21% by weight aromatic petroleum distillates.

Using a projection printer, the resist was exposed to radiation (wavelength ranged from about 350 to about 450 nm), at a dosage of about 90 mJ/cm2, through a mask with various line/space arrays.

The irradiated resist was subsequently treated with a solution of about 10% by weight HMCTS in xylene, at about 65°C, for a period of about 3 minutes.

The irradiated, HMCTS treated resist was then reactive ion etched in oxygen. The irradiated areas were etched away; the non-irradiated areas showed no detectable resist loss of the original 2.5 micron film. Line/space arrays down to one micrometer in size were produced. Irradiation of the photoactive compound in the presence of the polyamic acid resin altered the chemical and/or matrix structure of the resist film, hindering leachability of the photoactive compound from the resist film; thus, the HMCTS silylating solution was unable to significantly penetrate the irradiated areas of the film.

It should be noted that resist coated wafers prepared using a resist formulation comprised of about 15% by weight of the polyamic acid resin, 64% by weight NMP, and about 21% by weight aromatic petroleum distillates (absent the tricyclodecane photoactive compound), treated with HMCTS solution as described above had not silylated to any significant degree, and the resist film could be etched away in oxygen.

The method of the present invention can be used to provide an etch resistant patterned resist film or a wet-developable patterned film for lithographic applications; the method can be used to create an etch barrier for semiconductor processing or insulating layer in a semiconductor device. The method of the present invention can also be used to enable etching of isolation cavities or trenches in the substrate underlaying the resist structure.

To enable etching of isolation cavities or trenches in the substrate underlaying the resist structure, the resist formulation is applied to the surface of the substrate using techniques known in the art. The surface of the resist layer so created is patternwise exposed to irradiation capable of creating the desired latent image within the resist layer. The resist layer is treated with an organometallic reagent to produce a pattern of organometallic material within at least the upper portion of the resist layer. The resist is oxygen plasma etched to develop a patterned resist layer atop the substrate. The resist/substrate structure is then etched using a plasma comprising a halogen gas capable of etching both the organometallic comprised resist and the underlaying substrate. A typical halogen gas is comprised of a mixture of CF4 and SF6. When a positive tone resist is used, presence of the organometallic material in the resist delays etching of the underlaying substrate, so that cavities are generated only in the exposed areas of substrate. The etching process is terminated when the cavity or trench is etched to the desired depth. By proper adjustment of the depth of penetration of the organometallic compound, and adjustment of the reactive ion etch parameters, the patterned, organometallic-containing top portion of the resist can be etched away during the trench etching. The bottom portion of the resist structure remaining can be removed using reactive ion etching with halogen gas or with oxygen; however, it is preferred to etch the bottom portion of the resist structure remaining (which does not contain organometallic compound) with an oxygen plasma which is not capable of etching the underlaying substrate.

## Claims

1. A method of forming a resist film characterized in that it includes the steps of:
a) providing a polymeric material comprising at least one polymer and one solvent;
b) adding a leachable additive to said polymeric material selected in the group comprising 1-1′-(dodecamethylene) bis (2,4-piperidinedione), 4,4′-bis (dimethylamino)-benzophenone and 4,8-bis((6-diazo-5,6-dihydro-5-oxo-1-naphthanyl sulfonyloxymethyl)tricyclo(5.2.1.02,6) decane to generate a resist formulation;
c) apply said resist formulation onto a substrate to form a resist film;
d) heat treating the resist film to remove the solvent;
e) patternwise irradiating said resist film to create a latent image therein; and,
f) treating the irradiated resist film with an organometallic compound.

2. The method of claim 1 further including the step of:
g) RIE etching the treated irradiated resist film in oxygen.

3. The method of claim 1 or 2 wherein said organometallic compound comprises an organosilicon compound.

4. The method of claim 3 wherein said organosilicon compound is HMCTS.

## Patentansprüche

1. Verfahren zur Erzeugung eines Resistfilmes, dadurch gekennzeichnet, daß es folgende Schritte beinhaltet:
a) Bereitstellen eines polymeren Materials, das wenigstens ein Polymer und ein Lösungsmittel beinhaltet;
b) Hinzufügen eines extrahierbaren Additives zu dem polymeren Material, das aus der Gruppe gewählt wird, die 1-1′-(Dodecamethylen)bis(2,4-piperidindion), 4,4′-Bis-(dimethylamino)-benzophenon sowie 4,8-Bis((6-diazo-5,6-dihydro-5-oxo-1-naphthanylsulfonyloxymethyl)tri-cyclo(5.2.1.02,6)decan beinhaltet, um ein Resistausgangsgemisch zu erzeugen;
c) Aufbringen des Resistausgangsgemisches auf einem Substrat, um einen Resistfilm zu bilden;
d) Wärmebehandeln des Resistfilmes, um das Lösungsmittel zu entfernen;
e) strukturiertes Bestrahlen des Resistfilmes, um eine latente Abbildung in demselben zu erzeugen; und
f) Behandeln des bestrahlten Resistfilmes mit einer organometallischen Verbindung.

2. Verfahren nach Anspruch 1, das des weiteren folgenden Schritt beinhaltet:
g) RIE-Ätzen des behandelten bestrahlten Resistfilmes in Sauerstoff.

3. Verfahren nach Anspruch 1 oder 2, wobei die organometallische Verbindung eine Organosiliciumverbindung beinhaltet.

4. Verfahren nach Anspruch 3, wobei die Organosiliciumverbindung HMCTS ist.

## Revendications

1. Procédé de formation d'une couche de photorésist caractérisé en ce qu'il comprend les étapes consistant à:
a) fournir un corps polymère comprenant au moins un polymère et un solvant;
b) ajouter un adjuvant lessivable au dit corps polymère choisi dans le groupe comprenant 1-1′-(dodécaméthylène) bis (2,4-pipéridinédione), 4,4′-bis (diméthylamino)-benzophène et 4,8-bis((6-diazo-5,6-dihydro-5-oxo-1-naphtanyl sulfonyloxyméthyle)tricyclo(5.2.1.02,6)décane pour générer une composition de résist;
c) appliquer ladite composition de résist sur un substrat pour former une couche de résist;
d) traiter à la chaleur la couche de résist pour éliminer le solvant;
e) irradier selon un motif ladite couche de résist pour créer une image latente dans celle-ci; et
f) traiter la couche de résist irradiée avec un composé organo-métallique.

2. Procédé selon la revendication 1 comprenant, de plus, I'étape consistant à:
g) attaquer par ions réactifs la couche de résist irradiée traitée dans de l'oxygène.

3. Procédé selon la revendication 1 ou 2 dans lequel ledit composé organo-métallique comprend un composé organo-silicique.

4. Procédé selon la revendication 3 dans lequel ledit composé organo-silicique est de l'hexaméthylcyclotrisilazane (HCMTS).
